# EUROPÄISCHE PATENTSCHRIFT

(11) **EP 1 168 443 B1**
(45) Veröffentlichungstag und Bekanntmachung des Hinweises auf die Patenterteilung: **14.03.2007**
(21) Anmeldenummer: 01113931.8
(22) Anmeldetag: 07.06.2001
(51) Int. Cl.: H01L 23/525, H01L 21/8242, H01L 21/768, H01L 21/3213

(54) **Verfahren zur Herstellung einer dielektrischen Antifuse-Struktur**
Process for the manufacture of a dielectric antifuse structure
Procédé pour la fabrication d'une structure antifusible diéléctrique

(30) Priorität: 22.06.2000 DE 10030444
(43) Veröffentlichungstag der Anmeldung: 02.01.2002
(73) Patentinhaber: Infineon Technologies AG, 81669 München (DE)
(72) Erfinder: Lehr, Matthias, Dr., 01309 Dresden (DE); Tews, Rene, Dr., 01099 Dresden (DE)
(74) Vertreter: Epping - Hermann - Fischer

(56) Entgegenhaltungen:
- EP-A- 0 539 197
- US-A- 5 614 756
- US-A- 6 008 075
- US-A- 6 025 226

## Beschreibung

Die Erfindung betrifft ein Verfahren zur Herstellung einer dielektrischen Antifuse-Struktur.

Derartige Antifuse-Strukturen stellen Verbindungselemente dar, die in integrierten Schaltungen eingesetzt werden, um beispielsweise redundante Speicherzellen in DRAMs zu aktivieren. Weiterhin können Antifuse-Strukturen dazu verwendet werden, um in Chips Kennungen einzuschreiben oder um Funktionalitäten von Chips gezielt zu ändern. Insbesondere können Antifuse-Strukturen auf dem Gebiet der FPGAs als programmierbare Verbindungselemente eingesetzt werden.

Eine dielektrische Antifuse-Struktur weist eine dielektrische Schicht auf, welche zwischen zwei leitenden Strukturen angeordnet ist. Solange die dielektrische Schicht intakt ist, fließt über die Antifuse-Struktur kein Strom. Durch Anlegen einer vorgegebenen Spannung kann die dielektrische Schicht zerstört werden, so dass dann über die Antifuse-Struktur ein Strom fließen kann.

Derartige Antifuse-Strukturen können in Kontaktlöcher eingearbeitet werden, welche in einer Oxidschicht angeordnet sind. In der Ebene der Oxidschicht wird dabei zudem eine vorgegebene Anzahl von weiteren Kontaktlöchern eingearbeitet, die zur Herstellung von Kontakten dienen.

Derartige Kontakte, die beispielsweise aus Wolfram oder Polysilizium bestehen, verbinden dann Leitbahnen in Leitbahnebenen und/oder eine Siliziumschicht mit integrierten Schaltungen, wobei die Leitbahnebenen und/oder die Siliziumschicht an der Unter- und Oberseite der Oxidschicht angrenzen.

Zur Erzeugung derartiger Strukturen werden zunächst Kontaktlöcher in vorgegebenen Positionen in die Oxidschicht eingeätzt. Für den Fall, dass die Leitbahnen aus Wolfram bestehen und die an deren Unterseite angeordneten Kontakte aus Wolfram und/oder Polysilizium bestehen, werden zur Erzeugung der aus Polysilizium bestehenden Kontakte die entsprechenden Kontaktlöcher mit Polysilizium befüllt, während die Kontaktlöcher zur Erzeugung von Kontakten aus Wolfram zunächst leer bleiben. Danach wird eine organische Anti-Reflex-Schicht auf die Oxidschicht aufgetragen. Anschließend wird eine Photoresist-Schicht auf die organische Schicht aufgetragen.

Falls in der Oxidschicht nur Kontakte und keine Antifuse-Strukturen erzeugt werden, erfolgt die Herstellung der Kontakte und der darüber liegenden Leitbahnen in folgenden Verfahrensschritten:

In der Resistschicht werden entsprechend den Geometrien der zu erzeugenden Leitbahnen Öffnungen erzeugt. Durch diese Öffnungen erfolgt zunächst die Ätzung der organischen Anti-Reflex-Schicht. Bei diesem Ätzprozess wird zwangsläufig auch ein Teil der darüber liegenden Resistschicht mit verbraucht. Danach erfolgt durch die so erzeugten Öffnungen die Ätzung von Gräben in der Oxidschicht, wobei diese Gräben in den Bereichen der Kontaktlöcher an deren Oberseiten anschließen.

Bei diesen Ätzprozessen werden insbesondere auch Reste von der organischen Anti-Reflex-Schicht aus den Kontaktlöchern vollständig entfernt.

Für den Fall, dass einige der Kontaktlöcher zur Herstellung von Antifuse-Strukturen verwendet werden, wird unterhalb der organischen Anti-Reflex-Schicht eine dielektrische Schicht abgeschieden.

In Kontaktlöchern zur Erzeugung von Antifuse-Strukturen ist als erste leitende Schicht beispielsweise eine Polysilizium-Schicht eingebracht, auf deren Oberseite die dielektrische Schicht aufliegt. Dasselbe gilt für mit Polysilizium befüllte Kontaktlöcher zur Herstellung von Kontakten. In den Kontaktlöchern zur Erzeugung von Kontakten aus Wolfram befindet sich dagegen keine dielektrische Schicht.

Bei der nachfolgenden Ätzung der organischen Anti-Reflex-Schicht und der Oxidschicht befinden sich die Öffnungen der Resistschicht nur oberhalb der Kontaktlöcher zur Erzeugung von Kontakten, nicht jedoch oberhalb der Kontaktlöcher zur Erzeugung von Antifuse-Strukturen.

Nach der Ätzung der organischen Anti-Reflex-Schicht verbleiben Reste dieser Schicht in den Kontaktlöchern zur Herstellung von Kontakten.

Dies ist unkritisch für nicht mit Polysilizium befüllte Kontaktlöcher, da dort die Reste der Anti-Reflex-Schicht auf dem Boden der jeweiligen Kontaktlöcher aufliegen und dabei die darunter liegende Schicht, beispielsweise eine SiliziumSchicht, mit darin angeordneten integrierten Schaltungen schützt.

Problematisch sind jedoch die in Kontaktlöchern befindlichen Reste der organischen Anti-Reflex-Schicht, die auf der dielektrischen Schicht aufliegen, welche wiederum auf dem Polysilizium aufliegt.

Um die Reste der organischen Anti-Reflex-Schicht aus diesen Kontaktlöchern herauszulösen, müsste die Dauer des Ätzprozesses zur Entfernung der organischen Anti-Reflex-Schicht verlängert werden. Dadurch würde der Verbrauch der darüber liegenden Resistschicht unerwünscht hoch, wodurch eine Verbreiterung der zu ätzenden Gräben für die Leitbahnen erhalten würde. Dadurch würden die Profile der Leitbahnen verbreitert und entsprächen nicht mehr den geforderten Abmessungen.

Aus der US 5,602,053 ist ein Verfahren zur Herstellung einer Antifuse-Struktur beschrieben. Die Antifuse-Struktur ist zwischen zwei leitenden Kontakten angeordnet. Jeder Kontakt weist eine seitliche Grenzschicht aus Titan-Nitrid, Titan-Wolfram oder Tantal-Nitrid auf. Innerhalb der Grenzschicht ist eine Schicht aus Aluminium, Kupfer, Wolfram oder Silber abgeschieden. Auf die obere Grenzfläche eines kontakts ist als Antifuse-Struktur eine Schichtstruktur aufgebracht, die aus vier übereinander liegenden Schlichten gebildet ist. Die erste Schicht besteht aus Siliziumnitrid und liegt auf der Grenzfläche des Kontakts auf. Auf die Silizium-Nitrid-Schicht ist eine Schicht aus amorphem Silizium aufgebracht, auf welcher wiederum eine Schicht aus Silizium-Nitrid aufgebracht ist. Auf dieser Schicht ist eine weitere Schicht aus amorphem Silizium aufgetragen. An deren Oberseite schließt schließlich der zweite Kontakt an.

Die US 5,874,201 betrifft ein Verfahren zur Herstellung eines Kontaktes zwischen zwei leitenden Schichten eines integrierten Schaltkreises. In einem ersten Verfahrensschritt wird ein Kontaktloch in eine Oxidschicht, vorzugsweise eine SiO₂-Schicht, eingeätzt. Auf diese SiO₂-Schicht wird eine organische Anti-Reflex-Schicht aufgebracht. Unter Ausnützung der Oberflächenspannung der organischen Anti-Reflex-Schicht wird diese auf die SiO₂-Schicht so aufgebracht, dass das Kontaktloch frei von der Anti-Reflex-Schicht bleibt. Die Anti-Reflex-Schicht bildet dabei einen Kranz um den oberen Rand des Kontaktlochs, wobei die Oberkante des Kranzes im Bereich des Randes des Kontaktloches gekrümmt verläuft.

Auf die organische Anti-Reflex-Schicht wird dann eine Resistschicht aufgebracht. Durch Ausnehmungen der Resistschicht wird die SiO2-Schicht im Bereich des Kontaktlochs nochmals geätzt, um definierte, vorzugsweise asymmetrische Profile des Kontaktloches zu erzeugen, in welches dann eine leitfähige Schicht zur Bildung des Kontaktes abgeschieden wird.

Aus der Druckschrift US 6,025,226 A ist ein Verfahren bekannt, bei dem ein zwei Leitbahnebenen verbindender Kontakt neben einem Kondensator hergestellt wird, welcher in dem gleichen Zwischenebenenisolator angeordnet ist wie der Kontakt. Es wird auf den Zwischenebenenisolator, welcher die entsprechenden Löcher für den Kontakt bzw. Kondensator aufweist, eine dielektrische Schicht abgeschieden. Die dielektrische Schicht dient im Falle des Kondensators als Kondensatordielektrikum. Zur Entfernung der dielektrischen Schicht von dem Kontaktloch wird das Kondensatorloch durch einen aufgebrachten Resist maskiert.

Über dem Kontaktloch hingegen werden im Resist lithografisch Öffnungen gebildet, so dass bei der Bildung von Leitbahngräben die dielektrische Schicht dort wieder entfernt werden kann. Anschließend wird auch der Resist entfernt. Die Leitbahnen mit dem Kontaktloch einerseits und das Kondensatorloch mit dem dort noch vorhandenen Dielektrikum andererseits werden schließlich mit leitendem Material verfüllt.

Der Erfindung liegt die Aufgabe zugrunde, ein Verfahren der eingangs genannten Art so auszubilden, dass eine Herstellung von Antifuse-Strukturen ohne Beeinträchtigung der Qualität von anderen Schaltungs-Strukturen ermöglicht wird.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Zur Herstellung einer dielektrischen Antifuse-Struktur wird gemäß dem erfindungsgemäßen Verfahren in einem ersten Verfahrensschritt eine dielektrische Schicht auf die Oberfläche einer Oxid-Schicht aufgebracht, welche wenigstens erste Kontaktlöcher zur Erzeugung von Kontakten und zweite Kontaktlöcher zur Erzeugung von Antifuse-Strukturen aufweist, wobei die Kontaktlöcher jeweils teilweise mit einer ersten leitenden Schicht befüllt sind.

Danach wird eine organische Anti-Reflex-Schicht auf die dielektrische Schicht aufgebracht.

Danach wird eine Resistschicht auf die organische Anti-Reflex-Schicht aufgebracht. In einem weiteren Verfahrensschritt erfolgt die Strukturierung der Resistschicht mittels eines Lithographieprozesses, wobei die zweiten Kontaktlöcher mit der Resistschicht bedeckt bleiben.

Darauf erfolgt das Ätzen der organischen Anti-Reflex-Schicht durch Öffnungen der Resistschicht oberhalb der ersten Kontaktlöcher und ein nachfolgendes Ätzen der Oxidschicht durch Öffnungen der organischen Anti-Reflex-Schicht zur Erzeugung von Gräben für Leitbahnstrukturen oberhalb der Kontakte.

Im Anschluss daran erfolgt ein Ätzen von Resten der Anti-Reflex-Schicht in den ersten Kontaktlöchern.

Darauf erfolgt ein Ätzen des freiliegenden Teils der dielektrischen Schicht in den ersten Kontaktlöchern.

Schließlich erfolgt das Entfernen der Resistschicht und der darunter liegenden Segmente der organischen Anti-Reflex-Schicht und das Abscheiden einer zweiten leitenden Schicht auf den Schichtsegmenten der dielektrischen Schichtsegmente der Antifuse-Strukturen.

Der Grundgedanke der Erfindung besteht somit darin, dass zur Erzeugung von Gräben in der Oxidschicht zur Herstellung von an den Oberseiten von Kontakten anschließenden Leitbahnen die Ätzung der organischen Anti-Reflex-Schicht derart erfolgt, dass bei der nachfolgenden Ätzung der Oxidschicht die geforderten Profile der Gräben für die Leitbahn erhalten werden. Dabei wird bewusst in Kauf genommen, dass sich insbesondere in Kontaktlöchern zur Erzeugung von Kontakten aus einer ersten leitenden Schicht, vorzugsweise aus Polysilizium, welche in diese Kontaktlöcher abgeschieden ist und auf welcher die dielektrische Schicht aufliegt, noch Reste der organischen Anti-Reflex-Schicht befinden.

Die in diesen Kontaktlöchern auf der dielektrischen Schicht aufliegenden Reste der organischen Anti-Reflex-Schicht werden dann in einem zweiten Ätzprozess im Anschluss an die Ätzung der Gräben in der Oxidschicht entfernt.

Hierzu wird ein Ätzprozess mit hoher Selektivität gegenüber der Oxidschicht gewählt. Bei diesem Ätzprozess werden die Grabenprofile in der Oxidschicht nicht beeinträchtigt, sondern allein die Reste der organischen Anti-Reflex-Schicht in den Kontaktlöchern zur Herstellung der Kontakte entfernt.

Danach wird die freiliegende dielektrische Schicht entfernt, worauf die Resistschicht, insbesondere oberhalb der Kontaktlöcher zur Erzeugung der Antifuse-Strukturen, entfernt wird.

Danach erfolgt die Abscheidung der zweiten leitenden Struktur in den Kontaktlöchern zur Herstellung der Antifuse-Struktur und auch die Abscheidung der leitenden Schichten zur Herstellung der Leitbahnen.

Auf diese Weise können die Antifuse-Strukturen mit hoher Prozesssicherheit hergestellt werden, ohne dass die Qualität der umliegenden Schaltungsstrukturen, insbesondere der Leitbahnen und der darunter liegenden Kontakte, beeinträchtigt wird.

In einer vorteilhaften Ausführungsform der Erfindung ist die Antifuse-Struktur von einer Polysilizium-Schicht gebildet, die in einem Kontaktloch abgeschieden ist. An deren Oberseite schließt die dielektrische Schicht an, die vorzugsweise von einer Si₃N₄-Schicht gebildet ist. Diese dielektrische Schicht erstreckt sich zudem an den Seitenwänden des Kontaktloches bis zu dessen oberen Rand. Auf diese dielektrische Schicht ist eine Adhäsionsschicht aufgebracht, die vorzugsweise von einer Titanschicht gebildet ist.

An deren Oberseite schließt als zweite leitende Schicht der Antifuse-Struktur eine Wolfram-Schicht an, mit welcher das Kontaktloch bis zum oberen Rand befüllt ist.

Vorzugsweise bestehen die Leitbahnen der oberhalb der Kontakte verlaufenden Leitbahnen ebenfalls aus Wolfram, so dass die Erzeugung der zweiten leitenden Schichten der Antifuse-Strukturen der Kontakte sowie der Leitbahnen in einem Prozessschritt erfolgen kann.

Die Erfindung wird im nachstehenden anhand der Zeichnungen erläutert. Es zeigen:
- Figur 1:: Schematische Darstellung eines Ausschnitts eines integrierten Schaltkreises mit einer erfindungsgemäßen Antifuse-Struktur.
- Figuren 2 - 5:: Schematische Darstellung verschiedener Verfahrensschritte zur Herstellung der Struktur gemäß Figur 1.

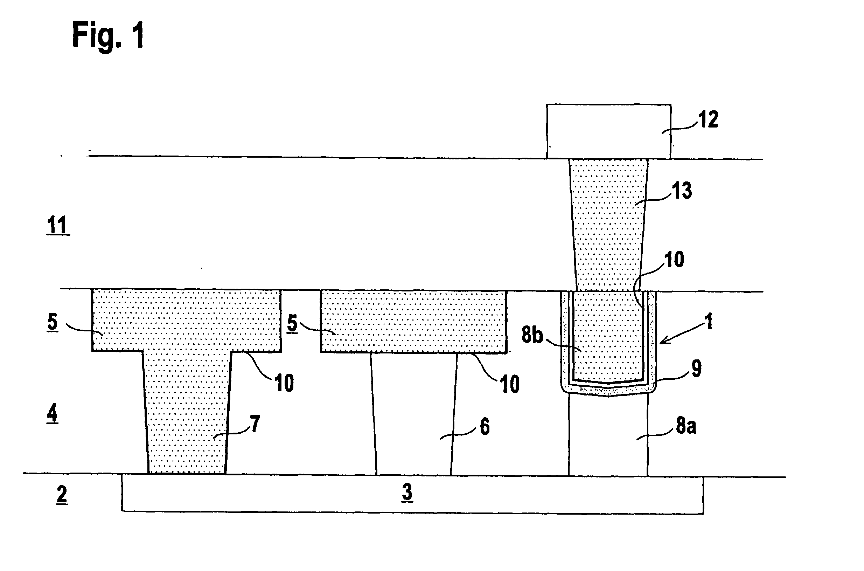

In Figur 1 ist schematisch ein Ausschnitt eines integrierten Schaltkreises mit einem Ausführungsbeispiel der erfindungsgemäßen Antifuse-Struktur 1 dargestellt.

Die in Figur 1 dargestellte Struktur weist eine Siliziumschicht 2 auf, wobei in einem aktiven Gebiet 3 der Siliziumschicht 2 integrierte Schaltungen eingearbeitet sind. Über der Siliziumschicht 2 liegt eine erste Oxidschicht 4, welche beispielsweise von einer SiO₂-Schicht gebildet ist. Oberhalb dieser Oxidschicht 4 verläuft eine erste Leitbahnebene. Zur Verbindung von Leitbahnen 5 in der Leitbahnebene mit dem aktiven Gebiet 3 der Siliziumschicht 2 sind in der Oxidschicht 4 verlaufende Kontakte 6, 7 vorgesehen. Zudem verläuft in der Oxidschicht 4 die erfindungsgemäße Antifuse-Struktur 1.

Die Leitbahnen 5 in der ersten Leitbahnebene bestehen aus Wolfram. Von diesen Leitbahnen 5 führen zur Siliziumschicht 2 einerseits Kontakte 6, die aus Polysilizium bestehen. Zudem führen von den Leitbahnen 5 zur Siliziumschicht 2 Kontakte 7, die aus Wolfram bestehen.

Die Antifuse-Struktur 1 weist eine erste leitende Schicht 8a auf, die aus Polysilizium besteht. Die Unterseite dieser Schicht 8a grenzt an das aktive Gebiet 3 der Siliziumschicht 2 an. Oberhalb der ersten leitenden Schicht 8a ist eine zweite leitende Schicht 8b vorgesehen, welche aus Wolfram besteht. Diese zweite leitende Schicht 8b verläuft im wesentlichen in der ersten Leitbahnebene.

Die beiden leitenden Schichten 8a, 8b der Antifuse-Struktur 1 sind durch eine dielektrische Schicht 9 getrennt. Die dielektrische Schicht 9 begrenzt dabei die Unterseite sowie die Seitenflächen der zweiten leitenden Schicht 8b. Im vorliegenden Ausführungsbeispiel besteht die dielektrische Schicht 9 aus Si₃N₄.

Zwischen der Wolframschicht und der dielektrischen Schicht 9 aus Si₃N₄ liegt eine Adhäsionsschicht 10, die vorzugsweise von einer dünnen Titanschicht gebildet ist.

Diese Adhäsionsschicht 10 liegt zudem an den Seitenrändern und Unterseiten der aus Wolfram bestehenden Leitbahnen 5 sowie an den Seitenrändern und der Unterseite des aus Wolfram bestehenden Kontaktes 7.

Bei der Antifuse-Struktur 1 fließt kein Strom über die leitenden Schichten 8a, 8b, solange die dielektrische Schicht 9 intakt ist. Durch Anlegen einer vorgegebenen Spannung an die Antifuse-Struktur 1 ist die dielektrische Schicht 9 zerstörbar, so dass dann ein Strom über die Antifuse-Struktur 1 fließen kann.

Diese Antifuse-Strukturen 1 können beispielsweise zur Aktivierung redundanter Speicherzellen in DRAMs eingesetzt werden. Zudem können die Antifuse-Strukturen 1 zum Einschreiben von Kennungen in Chips oder zur Änderung von Funktionalitäten von Chips verwendet werden.

Oberhalb der ersten Leitbahnebene befindet sich eine zweite Oxidschicht 11, an deren Oberseite eine zweite Leitbahnebene anschließt. In Figur 1 ist eine in der zweiten Leitbahnebene verlaufende Leitbahn 12 dargestellt, die aus Aluminium besteht. Diese Leitbahn 12 ist mit der zweiten leitenden Schicht 8b der Antifuse-Struktur 1 über einen in der zweiten Oxidschicht 11 verlaufenden Kontakt 13 verbunden. Dieser Kontakt 13 besteht wie die zweite leitende Schicht 8b aus Wolfram.

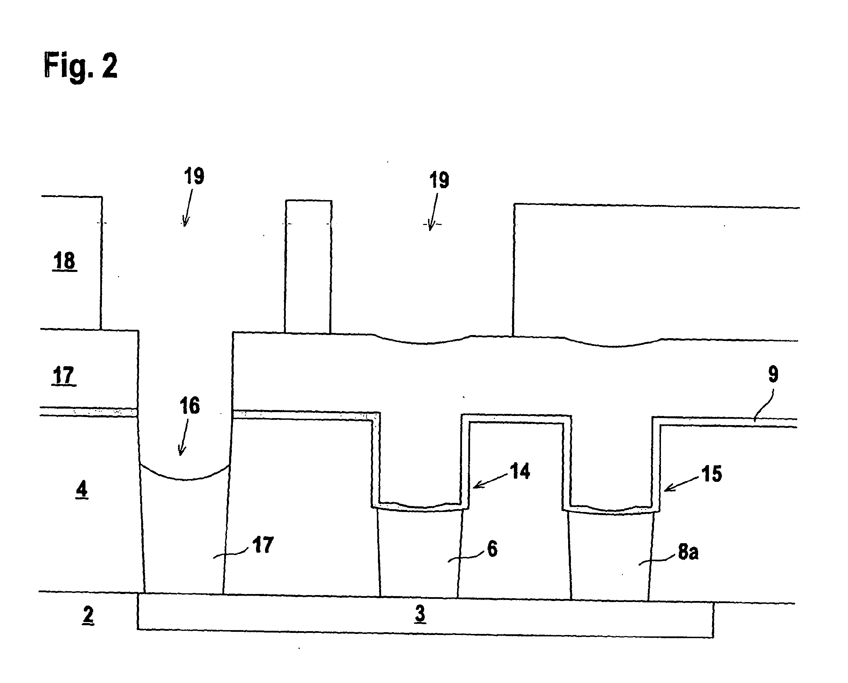

In den Figuren 2 - 5 sind die wesentlichen Verfahrensschritte zur Herstellung der erfindungsgemäßen Antifuse-Struktur 1 dargestellt.

In Figur 2 sind erste, zweite und dritte Kontaktlöcher 14, 15, 16 dargestellt, die in die erste Oxidschicht 4 eingeätzt sind und welche zur Herstellung der Kontakte 6, 7 und der Antifuse-Struktur 1 dienen. Die Kontaktlöcher 14, 15, 16 durchsetzen die Oxidschicht 4 jeweils vollständig, so dass diese jeweils an der Oberseite des aktiven Gebiets 3 der Siliziumschicht 2 ausmünden.

In die ersten und zweiten Kontaktlöcher 14, 15 ist jeweils eine Polysiliziumschicht abgeschieden. Die Polysiliziumschichten in den ersten Kontaktlöchern 14 bilden die aus Polysilizium bestehenden Kontakte 6, die zur ersten Leitbahnebene führen.

Die Polysiliziumschichten in den zweiten Kontaktlöchern 15 bilden die ersten leitenden Schichten 8a der Antifuse-Strukturen 1.

Die dritten Kontaktlöcher 16, in welchen sich kein Polysilizium befindet, dienen zur Herstellung der aus Wolfram bestehenden Kontakte 7.

Die dielektrische Schicht 9 zur Bildung der Antifuse-Strukturen 1 ist auf die Oxidschicht 4 sowie die Polysiliziumschichten in den ersten und zweiten Kontaktlöchern 14, 15 aufgebracht. Dagegen ist die dielektrische Schicht 9 in den Bereichen der dritten Kontaktlöcher 16 entfernt.

Auf die dielektrische Schicht 9 ist eine organische Anti-Reflex-Schicht 17 aufgebracht. Insbesondere sind die ersten und zweiten Kontaktlöcher 14, 15 mit der Anti-Reflex-Schicht 17 befüllt. Auch in den dritten Kontaktlöchern 16 befinden sich Teile der Anti-Reflex-Schicht 17.

Auf die organische Anti-Reflex-Schicht 17 ist eine Resistschicht 18 aufgebracht. Figur 2 zeigt die bei einem Lithographieprozess strukturierte Resistschicht 18. Die Resistschicht 18 weist Öffnungen 19 oberhalb der zweiten und dritten Kontaktlöcher 15, 16 auf. Diese Öffnungen 19 dienen zur Herstellung der oberhalb der ersten und dritten Kontaktlöcher 14, 16 verlaufenden Leitbahnen 5 in der ersten Leitbahnebene.

Dagegen sind oberhalb der zweiten Kontaktlöcher 15, die zur Herstellung der Antifuse-Strukturen 1 dienen, keine Öffnungen 19 in der Resistschicht 18 vorgesehen.

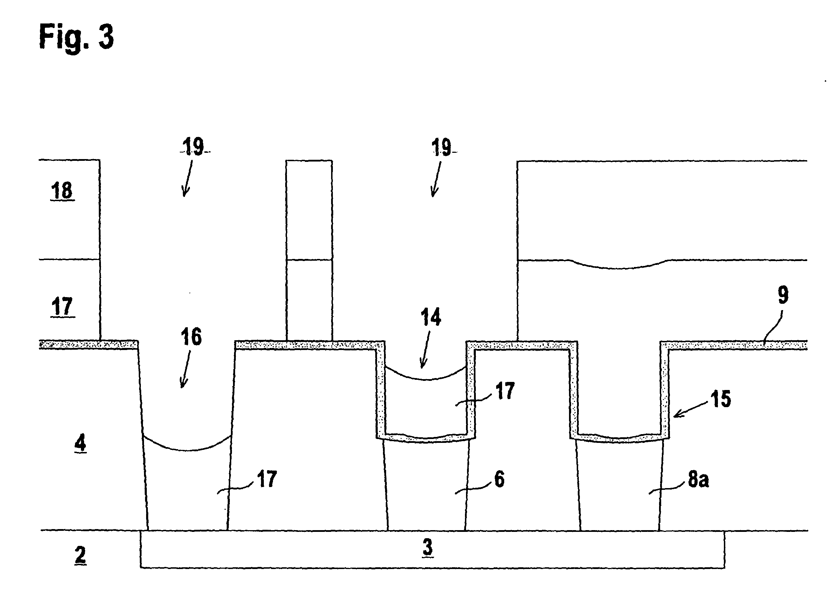

Durch die Öffnungen 19 der Resistschicht 18 erfolgt eine Ätzung der organischen Anti-Reflex-Schicht 17. Das Resultat dieser Ätzung ist in Figur 3 dargestellt. Zur Durchführung dieses Ätzprozesses wird vorzugsweise eine stark anisotrope Ätzchemie verwendet.

Die Ätzung der organischen Anti-Reflex-Schicht 17 durch die Öffnungen 19 der Resistschicht 18 erfolgt bis zu der auf der Oberseite der Oxidschicht 4 liegenden dielektrischen Schicht 9. Die Ätzchemie und die Ätzzeit des Ätzprozesses sind dabei so gewählt, dass die Profile der Öffnungen 19 der Resistschicht 18 erhalten bleiben und nicht verbreitert werden. Dafür wird in Kauf genommen, dass in den ersten und dritten Kontaktlöchern 14, 16 noch Reste der organischen Anti-Reflex-Schicht 17 verbleiben.

Die Reste der organischen Anti-Reflex-Schicht 17 in den dritten Kontaktlöchern 16 liegen auf der Oberseite des aktiven Gebietes 3 der Siliziumschicht 2 auf und schützen diese gegen Beschädigungen.

Die Reste der organischen Anti-Reflex-Schicht 17 in den ersten Kontaktlöchern 14 liegen dagegen auf der dielektrischen Schicht 9 auf und verhindern somit ein Entfernen der dielektrischen Schicht 9 in diesen Bereichen.

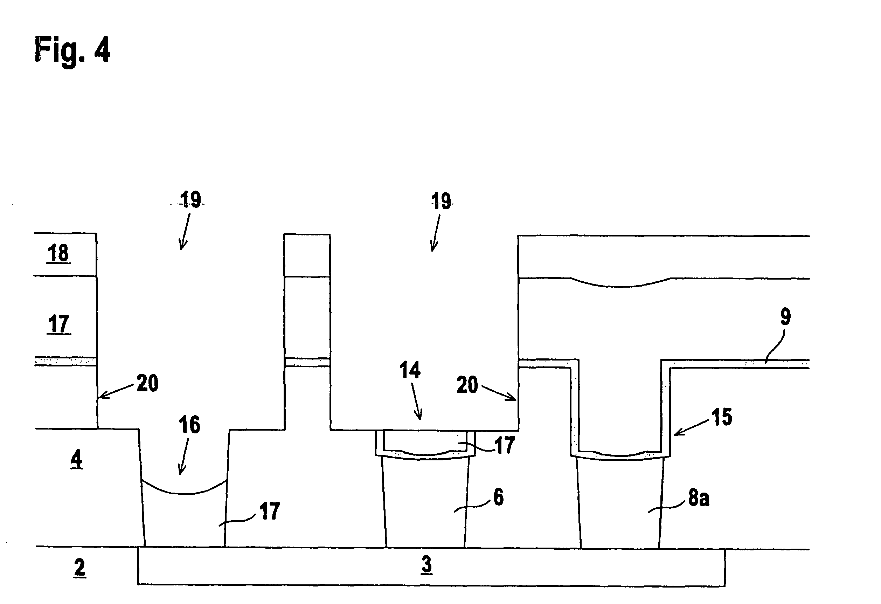

Im Anschluss an diesen ersten Ätzprozess erfolgt die Ätzung zur Erzeugung der Gräben 20 in der Oxidschicht 4, in welchen die Leitbahnen 5 der ersten Leitbahnebene verlaufen. Das Resultat dieser Grabenätzung ist in Figur 4 dargestellt.

Bei dieser Grabenätzung werden entsprechend den Geometrien der Öffnungen 19 der Resistschicht 18 in der Oxidschicht 4 Gräben 20 erzeugt, an deren Unterseiten die oberen Ränder der ersten und dritten Kontaktlöcher 14, 16 anschließen. Für diesen Ätzprozess wird vorzugsweise eine fluorhaltige Ätzchemie verwendet. Bei diesem Ätzprozess werden auch die freiliegenden Teile der dielektrischen Schicht 9 im Bereich der Gräben 20 entfernt. Auch Teile der in den ersten und dritten Kontaktlöchern 14, 16 liegenden Reste der organischen Anti-Reflex-Schicht 17 werden bei diesem Ätzprozess entfernt.

Jedoch verbleibt insbesondere in den ersten Kontaktlöchern 14 noch ein geringer Rest der Anti-Reflex-Schicht 17 mit der darunter liegenden dielektrischen Schicht 9.

Zur Entfernung dieser Reste der dielektrischen Schicht 9 wird erfindungsgemäß ein weiterer Ätzprozess durchgeführt.

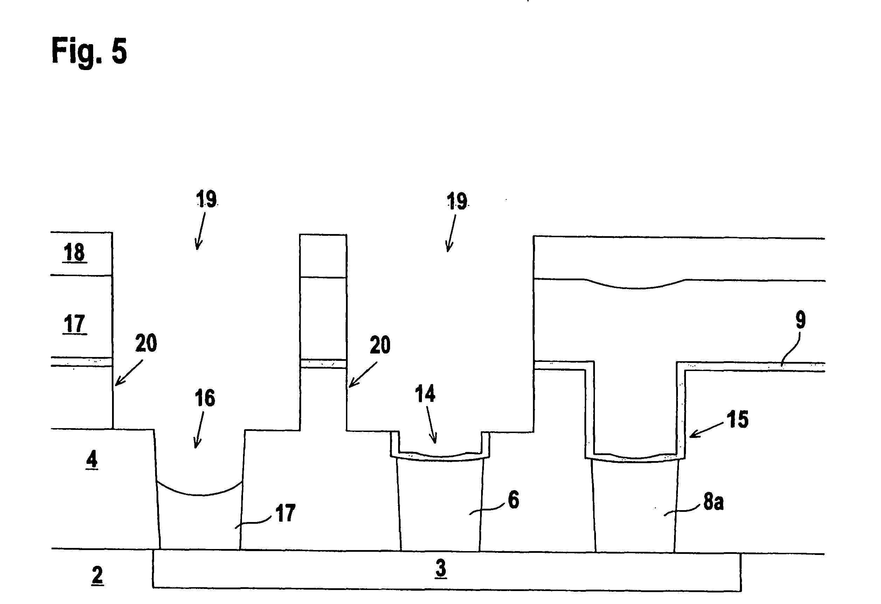

Hierzu wird vorteilhafterweise eine Ätzchemie verwendet, welche eine hohe Ätzselektivität zur Oxidschicht 4 aufweist. Eine derartige Ätzchemie besteht vorzugsweise aus N₂/O₂. Damit werden bei diesem Ätzprozess die Profile zur Erzeugung der Leitbahnen nicht beeinträchtigt, jedoch die Reste der organischen Anti-Reflex-Schicht 17 aus den ersten Kontaktlöchern 14 vollständig beseitigt. (Figur 5).

Anschließend wird die dielektrische Schicht 9 in den ersten Kontaktlöchern 14 mittels eines zweiten Ätzprozesses entfernt. Hierfür wird vorzugsweise die bereits bei der Grabenätzung verwendete fluorhaltige Ätzchemie verwendet.

Im Anschluss daran wird die Resistschicht 18 mit der darunter liegenden Anti-Reflex-Schicht 17 entfernt.

In einem weiteren Verfahrensschritt wird die Adhäsionsschicht 10 aufgetragen, welche die Leitbahnen 5, die Kontakte 7 sowie die zweite leitende Schicht 8b an deren seitlichen und unteren Rändern begrenzt.

Anschließend erfolgt die Abscheidung von Wolfram zur Erzeugung der aus Wolfram bestehenden Kontakte 6, 7 sowie der zweiten leitenden Schicht 8b der Antifuse-Strukturen 1. In demselben Abscheideprozess werden auch die Leitbahnen 5 der ersten Leitbahnebene erzeugt.

Anschließend wird die zweite Oxidschicht 11 aufgetragen, in welche die auf die Antifuse-Strukturen 1 geführten Kontakte 13 aus Wolfram eingearbeitet werden.

Schließlich werden die oberhalb der zweiten Oxidschicht 11 verlaufenden Leitbahnen 12 aus Aluminium in bekannter Weise hergestellt.

### Bezugszeichenliste

- 1: Antifuse-Struktur
- 2: Siliziumschicht
- 3: aktives Gebiet
- 4: erste Oxidschicht
- 5: Leitbahn
- 6: Kontakt
- 7: Kontakt
- 8a: erste leitende Schicht
- 8b: zweite leitende Schicht
- 9: dielektrische Schicht
- 10: Adhäsionsschicht
- 11: zweite Oxidschicht
- 12: Leitbahn
- 13: Kontakt
- 14: erstes Kontaktloch
- 15: zweites Kontaktloch
- 16: drittes Kontaktloch
- 17: Anti-Reflex-Schicht
- 18: Resistschicht
- 19: Öffnungen
- 20: Gräben

## Patentansprüche

1. Verfahren zur Herstellung dielektrischer Antifuse-Strukturen (1) umfassend folgende Verfahrensschritte:
- Aufbringen einer dielektrischen Schicht (9) auf die Oberfläche einer Oxidschicht (4) und in erste Kontaktlöcher (14) zur Erzeugung von Kontakten (6) und zweite Kontaktlöcher (15) zur Erzeugung von Antifuse-Strukturen (1), die in der Oxidschicht (4) angeordnet sind, wobei die Kontaktlöcher (14, 15) jeweils teilweise mit einer ersten leitenden Schicht (8a) befüllt sind, wobei die erste leitende Schicht in den ersten Kontaktlöchern (14) die Kontakte (6) bildet, und die erste leitende Schicht in den zweiten Kontaktlöchern (15) die erste leitende Schicht (8a) der Antifuse-Struktur (1) bildet.
- Aufbringen einer organischen Anti-Reflex-Schicht (17) auf die dielektrische Schicht (9) und in die Kontaktlöcher (14, 15),
- Aufbringen einer Resistschicht (18) auf der organischen Anti-Reflex-Schicht (17),
- Strukturierung der Resistschicht (18) mittels eines Lithographieprozesses, wobei die zweiten Kontaktlöcher (15) mit der Resistschicht (18) bedeckt bleiben,
- Ätzen der organischen Anti-Reflex-Schicht (17) durch Öffnungen (19) der Resistschicht (18) oberhalb der ersten Kontaktlöcher (14), so dass Reste der organischen Anti-Reflex-Schicht (17) innerhalb der ersten Kontaktlöcher (14) verbleiben,
- Entfernen der dielektrischen Schicht (9) und Ätzen der Oxidschicht (4) durch Öffnungen (19) der organischen Anti-Reflex-Schicht (17) zur Erzeugung von Gräben für Leitbahnstrukturen oberhalb der Kontakte (6),
- Ätzen der Reste der Anti-Reflex-Schicht (17) in den ersten Kontaktlöchern (14), mit einer hohen Ätzselektivität gegenüber der Oxidschicht (4),
- Ätzen des freiliegenden Teils der dielektrischen Schicht (9) in den ersten Kontaktlöchern (14),
- Entfernen der Resistschicht (18) und darunter liegende Segmente der organischen Anti-Reflex-Schicht (17,
- Abscheiden einer zweiten leitenden Schicht (8b) auf den Segmenten der dielektrischen Schicht (9) der Antifuse-Strukturen (1).

2. Verfahren nach Anspruch 1,
**dadurch gekennzeichnet, daß**
die zweite leitende Schicht (8b) oberhalb der Kontakte (6) zur Bildung von Leitbahnen (5) abgeschieden wird.

3. Verfahren nach einem der Ansprüche 1 oder 2,
**dadurch gekennzeichnet, daß**
dritte Kontaktlöcher (16) zur Erzeugung von Kontakten (7) vorgesehen sind, die nicht mit der ersten leitenden Schicht (8a) befüllt sind.

4. Verfahren nach Anspruch 3,
**dadurch gekennzeichnet, daß**
bei der Strukturierung der Resistschicht (18) in dieser oberhalb der dritten Kontaktlöcher (16) liegende Öffnungen zur Erzeugung von Leitbahnen (5) erzeugt werden.

5. Verfahren nach einem der Ansprüche 3 oder 4,
**dadurch gekennzeichnet, daß**
die dritten Kontaktlöcher (16) teilweise mit der organischen Anti-Reflex-Schicht (17) befüllt sind.

6. Verfahren nach einem der Ansprüche 3 - 5,
**dadurch gekennzeichnet, daß**
durch Abscheiden der zweiten leitenden Schicht (8b) in die dritten Kontaktlöcher (16) und die an deren Oberseiten angrenzenden Gräben (20) die Kontakte (7) und daran anschließend Leitbahnen (5) erzeugt werden.

7. Verfahren nach einem der Ansprüche 1-6,
**dadurch gekennzeichnet, daß**
die dielektrische Schicht (9) aus Si₃N₄ besteht

8. Verfahren nach einem der Ansprüche 1-7,
**dadurch gekennzeichnet, daß**
die erste leitende Schicht aus Polysilizium besteht.

9. Verfahren nach einem der Ansprüche 1-8,
**dadurch gekennzeichnet, daß**
die zweite leitende Schicht (8b) aus Wolfram besteht.

10. Verfahren nach Anspruch 9,
**dadurch gekennzeichnet, daß**
in den zweiten Kontaktlöchern (15) zwischen der dielektrischen Schicht (9) und der zweiten leitenden Schicht (8b) eine Adhäsionsschicht (10) vorgesehen ist.

11. Verfahren nach Anspruch 10,
**dadurch gekennzeichnet, daß**
die Adhäsionsschicht (10) von einer Ti-Schicht gebildet ist.

12. Verfahren nach einem der Ansprüche 1-11,
**dadurch gekennzeichnet, daß**
die Unterseiten der Kontaktlöcher (14, 15, 16) an eine Siliziumschicht (2), in welche integrierte Schaltungen eingearbeitet sind, angrenzen.

13. Verfahren nach einem der Ansprüche 1 - 12,
**dadurch gekennzeichnet, daß**
von der Oberseite einer Antifuse-Struktur (1) ein Kontakt (13) zu einer Leitbahn (12) führt.

14. Verfahren nach Anspruch 13,
**dadurch gekennzeichnet, daß**
der Kontakt (13) aus Wolfram und die Leitbahn (12) aus Aluminium besteht.

## Claims

1. Method for fabricating dielectric antifuse structures (1) comprising the following method steps:
- application of a dielectric layer (9) to the surface of an oxide layer (4) and into first contact holes (14) for producing contacts (6) and second contact holes (15) for producing antifuse structures (1), which are arranged in the oxide layer (4), the contact holes (14, 15) each being partly filled with a first conductive layer (8a), the first conductive layer in the first contact holes (14) forming the contacts (6), and the first conductive layer in the second contact holes (15) forming the first conductive layer (8a) of the antifuse structure (1).
- application of an organic antireflection layer (17) to the dielectric layer (9) and into the contact holes (14, 15),
- application of a resist layer (18) on the organic antireflection layer (17),
- patterning of the resist layer (18) by means of a lithography process, the second contact holes (15) remaining covered with the resist layer (18),
- etching of the organic antireflection layer (17) through openings (19) in the resist layer (18) above the first contact holes (14), so that residues of the organic antireflection layer (17) remain within the first contact holes (14),
- removal of the dielectric layer (9) and etching of the oxide layer (4) through openings (19) in the organic antireflection layer (17) for the purpose of producing trenches for interconnect structures above the contacts (6).
- etching of the residues of the antireflection layer (17) in the first contact holes (14) with a high etching selectivity with respect to the oxide layer (4),
- etching of the uncovered part of the dielectric layer (9) in the first contact holes (14),
- removal of the resist layer (18) and underlying segments of the organic antireflection layer (17),
- deposition of a second conductive layer (8b) on the segments of the dielectric layer (9) of the antifuse structures (1).

2. Method according to Claim 1,
**characterized in that**
the second conductive layer (8b) is deposited above the contacts (6) for the purpose of forming interconnects (5).

3. Method according to either of Claims 1 and 2,
**characterized in that**
provision is made of third contact holes (16) for producing contacts (7), which are not filled with the first conductive layer (8a).

4. Method according to Claim 3,
**characterized in that**
during the patterning of the resist layer (18), openings situated in the latter above the third contact holes (16) are produced for the purpose of producing interconnects (5).

5. Method according to either of Claims 3 and 4,
**characterized in that**
the third contact holes (16) are partly filled with the organic antireflection layer (17).

6. Method according to one of Claims 3-5,
**characterized in that**
the contacts (7) and afterward interconnects (5) are produced by deposition of the second conductive layer (8b) into the third contact holes (16) and the trenches (20) adjoining the top sides thereof.

7. Method according to one of Claims 1-6,
**characterized in that**
the dielectric layer (9) is composed of Si₃N₄.

8. Method according to one of Claims 1-7,
**characterized in that**
the first conductive layer is composed of polysilicon.

9. Method according to one of Claims 1-8,
**characterized in that**
the second conductive layer (8b) is composed of tungsten.

10. Method according to Claim 9,
**characterized in that**
an adhesion layer (10) is provided in the second contact holes (15) between the dielectric layer (9) and the second conductive layer (8b).

11. Method according to Claim 10,
**characterized in that**
the adhesion layer (10) is formed by a Ti layer.

12. Method according to one of claims 1-11,
**characterized in that**
the undersides of the contact holes (14, 15, 16) adjoin a silicon layer (2), in which integrated circuits are incorporated.

13. Method according to one of Claims 1-12,
**characterized in that**
from the top side of an antifuse structure (1), a contact (13) leads to an interconnect (12).

14. Method according to Claim 13,
**characterized in that**
the contact (13) is composed of tungsten and the interconnect (12) is composed of aluminium

## Revendications

1. Procédé de production de structures (1) antifusibles diélectriques, comprenant des stades de procédé suivants:
- on dépose une couche (9) diélectrique à la surface d'une couche (4) d'oxyde et dans de premiers trous (14) de contact pour la production de contacts (6) et dans de deuxièmes trous (15) de contact pour la production de structures (1) antifusibles qui sont disposées dans la couche (4) d'oxyde, les trous (14, 15) de contact étant remplis respectivement en partie d'une première couche (8a) conductrice, la première couche conductrice formant les contacts (6) dans les premiers trous (14) de contact et la première couche conductrice formant, dans les deuxièmes trous (15) de contact, la première couche (8a) conductrice de la structure (1) antifusible,
- on dépose une couche (17) organique antireflet sur la couche (9) diélectrique et dans les trous (14, 15) de contact,
- on dépose une couche (18) de réserve sur la couche (17) organique antireflet,
- on structure la couche (18) de réserve au moyen d'une opération de lithographie, les deuxièmes trous (15) de contact restant revêtus de la couche (18) de réserve,
- on attaque la couche (17) organique antireflet par des ouvertures de la couche (18) de réserve au-dessus des premiers trous (14) de contact de façon à ce que des restes de la couche (17) organique antireflet subsistent dans les premiers trous (14) de contact,
- on élimine la couche (9) diélectrique et on attaque la couche (4) d'oxyde par des ouvertures (19) de la couche (17) organique antireflet pour produire des sillons pour des structures de pistes conductrices au-dessus des contacts (6),
- on attaque les restes de la couche (17) antireflet dans les premiers trous (14) de contact avec une grande sélectivité d'attaque par rapport à la couche (4) d'oxyde,
- on attaque la partie mise à nu de la couche (9) diélectrique dans les premiers trous (14) de contact,
- on élimine la couche (19) de réserve et des segments sous-jacents de la couche (17) organique antireflet,
- on dépose une deuxième couche (8b) conductrice sur les segments de la couche (9) diélectrique des structures (1) antifusibles.

2. Procédé suivant la revendication 1,
**caractérisé en ce que**
on dépose la deuxième couche (8b) conductrice au-dessus des contacts (6) pour former des pistes (5) conductrices.

3. Procédé suivant l'une des revendications 1 ou 2,
**caractérisé en ce que**
on prévoit des troisièmes trous (16) de contact pour produire des contacts (7) qui ne sont pas remplis de la première couche (8a) conductrice.

4. Procédé suivant la revendication 3,
**caractérisé en ce que**
lors de la structuration de la couche (18) de réserve, on y produit des ouvertures se trouvant au-dessus des troisièmes trous (16) de contact et destinées à produire des pistes (5) conductrices.

5. Procédé suivant l'une des revendications 3 ou 4,
**caractérisé en ce que**
l'on remplit les troisièmes trous (16) de contact en partie de la couche (17) organique antireflet.

6. Procédé suivant l'une des revendications 3 à 5,
**caractérisé en ce que**
par dépôt de la deuxième couche (8b) conductrice dans les troisièmes trous (16) de contact et dans les sillons (20) voisins de leurs côtés supérieurs on produit les contacts (7) et les pistes (5) conductrices qui s'y raccordent.

7. Procédé suivant l'une des revendications 1 à 6,
**caractérisé en ce que**
la couche (9) diélectrique est en Si₃N₄.

8. Procédé suivant l'une des revendications 1 à 7,
**caractérisé en ce que**
la première couche conductrice est en polysilicium.

9. Procédé suivant l'une des revendications 1 à 8,
**caractérisé en ce que**
la deuxième couche (8b) conductrice est en tungstène.

10. Procédé suivant la revendication 9,
**caractérisé en ce que**
on prévoit une couche (10) d'adhérence dans les deuxièmes trous (15) de contact entre la couche (9) diélectrique et la deuxième couche (8b) conductrice.

11. Procédé suivant la revendication 10,
**caractérisé en ce que**
on forme la couche (10) d'adhérence par une couche de Ti.

12. Procédé suivant l'une des revendications 1 à 11,
**caractérisé en ce que**
les côtés inférieurs des trous (14, 15, 16) de contact sont voisins d'une couche (2) de silicium, dans laquelle sont incorporés des circuits intégrés.

13. Procédé suivant l'une des revendications 1 à 12,
**caractérisé en ce qu'**un contact mène du côté supérieur d'une structure (1) antifusible à une piste (12) conductrice.

14. Procédé suivant la revendication 13,
**caractérisé en ce que**
le contact (13) est en tungstène et la piste (12) conductrice est en aluminium.
